# EUROPEAN PATENT APPLICATION

(11) **EP 4 675 290 A1**
(43) Date of publication of application: **07.01.2026**
(21) Application number: 24185809.1
(22) Date of filing: 01.07.2024
(51) Int. Cl.: G01R 31/367, G01R 31/396, G06N 3/02

(54) **A SYSTEM, AND CORRESPONDING METHOD, FOR MONITORING AN ELECTRIC BATTERY SYSTEM**

(71) Applicant: Dukosi Limited, Edinburgh EH3 8RA (GB)
(72) Inventor: MACINNES, Robbie, Fife, KY12 0SR (GB)
(74) Representative: Finnegan Europe LLP

(57) **Abstract**

The present disclosure relates to a means to train and use a machine learning model to detect the anomalous behaviour of individual battery cells of an electric battery system.

## Description

### BACKGROUND

Battery systems, comprising a plurality of battery cells, are used in a wide range of modern electric power applications. For example, they are used to power electric vehicles, they are used in industrial power applications, in transportation, and in commercial applications such as powering of modern electronic devices. Given the relatively high-power demands of such applications, a battery system often comprises a plurality of battery cells coupled together to achieve the required power output. The battery cells may be coupled together to form a battery pack, and the battery system may comprise one or more battery packs.

The individual cells in a battery pack may diverge in performance over time due to different rates of degradation. The monitoring of cells enables safe operation and the detection of cell degradation and potential faults in the electrical battery system. Individual cells may also have manufacturing faults or may have been subjected to physical damage. Degradation may have occurred to the pack as a whole, for instance lithium plating or dendrite growth, but failure will typically start with a single cell, for instance when a dendrite causes a short circuit to a single cell, leading eventually to cell thermal runaway. Early detection of a single cell that is behaving in an anomalous fashion compared to the rest of the pack may allow a pack to be taken out of service, or repaired, before a fault manifests itself.

### SUMMARY

Individually monitoring each cell enables early intervention, thereby preventing a battery being operated in an unsafe state. This approach is especially useful for identifying cells that exhibit anomalous and detrimental behaviour, thus maintaining the overall efficiency and safety of the battery system.

Current technology involves monitoring the voltage and temperature of cells in a battery pack and setting static thresholds to identify cells that are over/under voltage or overheating. However, this approach has limitations due to its inability to adapt to the dynamic operational conditions and unique characteristics of individual cells. Further solutions used to tackle this problem include model-based methods. These techniques primarily involve developing a mathematical or physical model which describes the expected activity of the system. Such methods heavily rely on accurate battery models, entail substantial characterisation, particularly for complex electrochemical models.

The present disclosure describes solutions to alleviate or overcome one or more of the above-stated problems, among other problems existing in the prior art. Thus, the example embodiments presented herein provide a means to train a machine learning model and use this machine learning model to detect the anomalous behaviour of individual battery cells. According to some of the example embodiments, the machine learning training and monitoring may be performed while adapting to the use condition of the battery system and electric vehicle in general. Accordingly, the example embodiments are directed towards a device, and corresponding method, for training a machine learning model and monitoring an electric battery system.

Some of the example embodiments described herein are directed towards a method of training a machine learning model for monitoring an electric battery system, where the electric battery system comprises at least one pack and each pack comprises a plurality of individual cells. The method further includes obtaining a data set comprising a plurality of at least one of a voltage, current, temperature or pressure cell-level measurement for each of the plurality of cells. The method also comprises initializing an embedding vector for each of the plurality of cells. Thereafter, concatenating cell-level measurement data for respective individual cells with a respective embedding vector for the data set. The method also comprises inputting the concatenated data of the data set to the machine learning model and outputting a processed data set from the machine learning model. Thereafter, updating parameters of the respective embedding vectors and the machine learning model at each iteration of the training of the machine learning model based on minimizing a loss function. The loss function is based on a comparison of the data set and the processed data set. Upon the iteration, the respective embedding vectors define relationships between individual cells which are expected to perform in a similar manner and a numerical representation to identify each cell in a vector space used for evaluating cell behaviour. The machine learning model is configured to predict a behaviour of normal cell operation.

Some of the example embodiments disclosed herein are directed towards, a training unit for training a machine learning model for monitoring an electric battery system, where the electric battery system comprises at least one pack, and each pack comprises a plurality of individual cells. The training unit comprises a receiving unit configured to obtain a data set comprising a plurality of at least one of a voltage, current, temperature or pressure cell-level measurement for each of the plurality of cells. The training unit also comprises a processing unit configured to initialize an embedding vector for each of the plurality of cells. The processing unit is further configured to concatenate cell-level measurement data for respective individual cells with a respective embedding vector for the data set. The processing unit is additionally configured to input the concatenated data of the data set to the machine learning model. The processing unit is further configured to receive processed data set as output from the machine learning model. The processing unit is additionally further configured to update parameters of the respective embedding vectors and the machine learning model at each iteration of the training of the machine learning model based on minimizing a loss function. The loss function is based on a comparison of the data set and the processed data set. Upon the iteration, the respective embedding vectors define relationships between individual cells which are expected to perform in a similar manner and a numerical representation to identify each cell in a vector space used for evaluating cell behaviour. The machine learning model is configured to predict a behaviour of normal cell operation.

Some of the example embodiments disclosed herein are directed towards a computer-readable medium storing instructions, which, when executed by a processor of a training unit, the instructions cause the training unit to execute the method as described above. The training unit is configured for training a machine learning model for monitoring an electric battery system, where the electric battery system comprises at least one pack, each pack comprising a plurality of individual cells.

Some of the example embodiments disclosed herein are directed towards, a method for detecting anomalous behavior of cells in an electric battery system, where the electric battery system comprises at least one pack, each pack comprises a plurality of individual cells, said method uses a machine learning model, where the machine learning model is trained as explained above. The method further includes recording real-time data comprising a plurality of at least one of a voltage, current, temperature or pressure cell-level measurement for each of the plurality of cells while the electric battery system is operating. The method also comprises defining a measured data set once an amount of recorded real-time data has surpassed a predetermined threshold. Thereafter, inputting the dataset in the trained machine learning model, where the steps taken by the trained machine learning model include determining a predicted data set, where the predicted data set defines at least one of a voltage, current, temperature or pressure cell-level measurement for each of the plurality of cells during normal operation for each of the plurality of cells. The steps taken by the trained machine learning model further include calculating an error function, where the error function is representative of the difference between the predicted data set and the measured data set for each of the plurality of cells. The steps taken by the trained machine learning model also include identifying anomalous cells based on the error function.

Some of the example embodiments disclosed herein are directed towards an anomaly detection unit for detecting anomalous behavior of cells in an electric battery system, where the electric battery system comprises at least one pack and each pack comprises a plurality of individual cells. The method uses a machine learning model, where the machine learning model is trained as explained above. The anomaly detection unit comprises a processing unit configured to record real-time data comprising a plurality of at least one of a voltage, temperature or pressure cell-level measurement for each of the plurality of cells while the electric battery system is operating. The processing unit is further configured to define a measured data set once an amount of recorded real-time data has surpassed a predetermined threshold. The processing unit is further configured to input the dataset in the trained machine learning model, where the steps taken by the trained machine learning model include the processing unit further configured to determine a predicted data set, where the predicted data set defines at least one of a voltage, current, temperature or pressure cell-level measurement for each of the plurality of cells during normal operation for each of the plurality of cells. The steps taken by the trained machine learning model further include the processing unit further configured to calculate an error function, where the error function is representative of the difference between the predicted data set and the measured data set for each of the plurality of cells. The steps taken by the trained machine learning model also includes the processing unit further configured to identify anomalous cells based on the error function.

Some of the example embodiments disclosed herein are directed towards a computer-readable medium storing instructions, which, when executed by a processor of an anomaly detection unit, the instructions cause the training unit to execute the method as described above. The training unit is configured for detecting anomalous behavior of cells in an electric battery system where the electric battery system comprises at least one pack and each pack comprises a plurality of individual cells. The method uses a machine learning model, where the machine learning model is trained as described above, the instructions cause the anomaly detection unit to execute the method described above.

### BRIEF DESCRIPTION OF THE DRAWINGS

The foregoing will be described in more detail with the following more particular description of the example embodiments, as illustrated in the accompanying drawings in which reference characters refer to the same parts throughout the different views. The drawings are not necessarily to scale, emphasis instead being placed upon illustrating the example embodiments.
**FIG. 1** is a schematic of an electric battery system, according to some of the example embodiments presented herein;
**FIGS. 2A-2D** are flow diagrams providing an overview of training and use of a machine learning model for anomaly detection, according to some of the example embodiments presented herein;
**FIG. 3A-3B** are graphs illustrating the segmentation and sampling of a data set used to train the machine learning model of **FIGS. 2A-2D**, according to some of the example embodiments presented herein;
**FIGS. 4A-4C** are illustrative examples of data structures used for data analysis of data measured on battery cells, according to some of the example embodiments presented herein;
**FIG. 5A** is a flow diagram depicting operations taken during the training and use of the machine learning model of **FIG. 2A-2D**, according to some of the example embodiments presented herein;
**FIG. 5B** is a schematic representation of the machine learning model.
**FIGS. 6A-6B** are graphs illustrating the input and output of the machine learning model of **FIGS. 2A-2D** for a normal cell and an anomalous cell, respectively, according to some of the example embodiments presented herein;
**FIG. 7** is a graph illustrating anomaly detection using a clustering method, according to some of the example embodiments presented herein;
**FIGS. 8A-8B** are graphs illustrating anomaly detection using a dynamic threshold method, according to some of the example embodiments presented herein;
**FIG. 9** is a schematic representation of a computational unit used for anomaly detection and model training, according to some of the example embodiments presented herein;
**FIG. 10** is a flow diagram depicting operation steps taken by the computational unit of **FIG. 9** during the training of the machine learning model of **FIGS. 2A-****2D**, according to some of the example embodiments presented herein; and,
**FIG. 11** is a flow diagram depicting operation steps taken by the computational unit of **FIG. 9** during the use of the machine learning model of **FIGS. 2A-2D** for anomaly detection, according to some of the example embodiments presented herein.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

A battery system typically comprises multiple battery cells wired in a configuration to provide the desired battery system voltage and capacity and additional parts necessary for the safe operation of the cells and transfer of energy to/from the cells. A cell is the basic unit of any battery system. The defining characteristic of a cell is its electrochemical characteristics. For a particular cell chemistry, there is a minimum, typical and maximum voltage that is determined by the electrochemistry of the battery cells, rather than the configuration of the system. These voltages cannot be varied other than by changing the electrochemical state of the cell. Cells may be wired in parallel, to increase the overall capacity, but these paralleled cells can simply be regarded from a cell monitoring perspective as a larger single cell since they still have the same voltage characteristics as determined by the electrochemistry.

Cells can also be wired in series. The series stack of cells has a voltage primarily determined by the stack configuration. The stack voltage will be the sum of the cell voltages. The stack voltage can be varied by adding or removing cells without changing their electrochemical state. Typically, the stack of cells will be charged and discharged, with their electrochemical state changing in tandem. Each cell must be monitored to ensure it stays within its safe operating range. According to some of the example embodiments presented herein, this is the job of the cell monitoring device (CMD). CMDs provide cell-level measurements such that separate measurements are taken on individual cells and the information obtained is with respect to an individual cell.

A battery pack consists of multiple cells in series. The battery pack provides the full battery system voltage. Multiple battery packs may be wired in parallel to increase the battery system capacity. The cells may be grouped into modules. The defining characteristic of a module is its physical configuration, for example, the number and connectivity between a number of cells. A module may comprise of any number of cells. A module comprises of two or more cells, or an entire pack. In the case of there being only a single pack in the battery system, then a module could encompass an entire battery system.

More often though, a pack is configured as multiple modules, where each module is configured from multiple cells in series. Multiple modules are then wired in series, or in parallel and in series. Modules that are configured to provide the full the battery system voltage and are wired in parallel may be considered as packs. A module has a defined size, shape and is typically packaged in an enclosure of some kind.

The module configuration is driven by the physical requirements of the battery pack. Often a module is configured to have a low enough voltage that it can be handled without there being an electrical shock hazard. Often a module is configured for a number of cells that matches the number of voltage sensor inputs on a cell monitoring device. A very common example is a twelve-cell monitoring device. A module then consists of twelve cells and a connection to a cell monitoring device. In many battery packs, the properties of the CMD define the configuration of a module, and the battery pack is then built from multiple such modules.

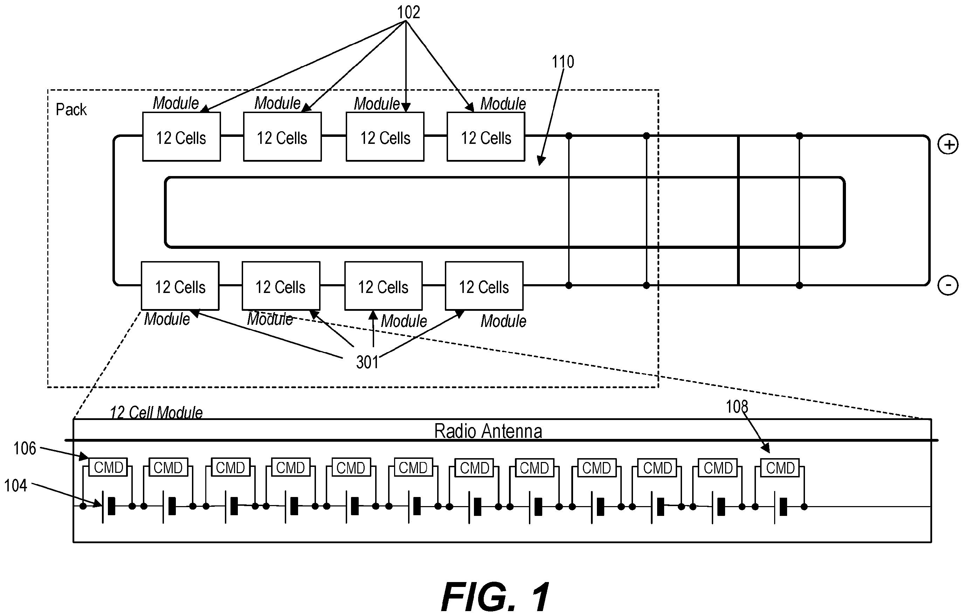

Figure 1 illustrates a battery pack featuring eight battery modules 102, with each module featuring twelve battery cells. Each battery cell 104 is in communication with a respective single cell CMD 106 which provides various measurements for the associated cell. According to some of the example embodiments, the CMDs are configured to obtain cell-level measurements of the respective cells being monitored. The cell-level measurements may include current, voltage, temperature and/or pressure. All the CMDs 106 are in communication with each other and a central controller via a radio antenna 108 and a wireless communications bus 110. It is understood that, as described herein, according to other example embodiments, each module features another number of battery cells, each battery cell being in communication with a respective CMD. According to yet another example embodiment, some of the modules may feature a different number of battery cells than the other modules of the same system. According to some of the example embodiments, each battery cell 104 may be in communication with a respective multiple cell CMD. In such embodiments, the multi-cell CMDs may be configured to obtain cell-level measurements of each of the cells it is connected to. It should be appreciated that a cell-level measurement can be obtained from a multiple CMD system using any means known in the art. For example, employing array reporting based on a first-in-first-out method and managing data readings in such a way that the reading and cell order is maintained, ensures that each reading is accurately associated with its respective cell.

The cell-level measurements obtained from the respective CMDs are used in the monitoring of individual battery cells to detect anomalous cells during the operation of the electric vehicle. According to some of the example embodiments presented herein, a machine learning model is used for such detection.

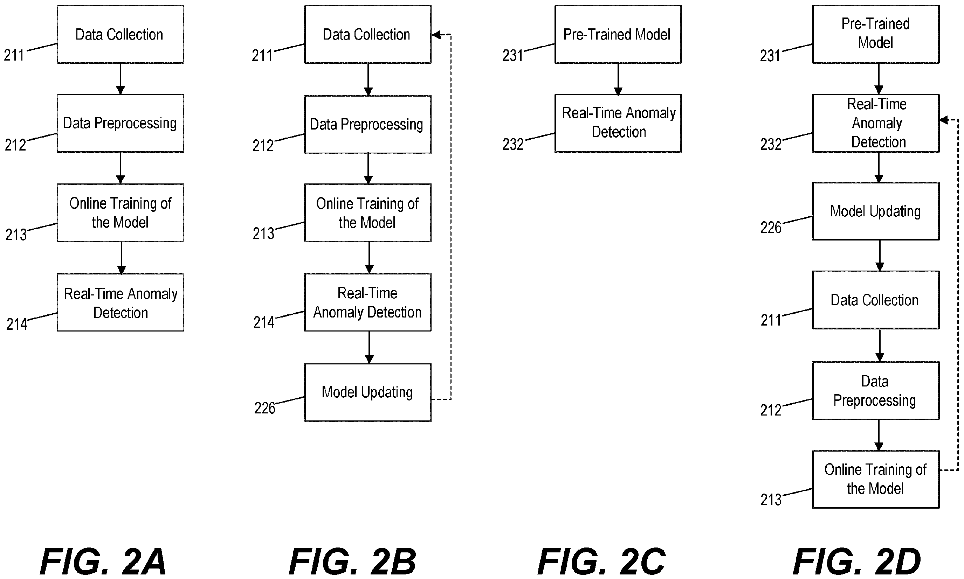

Figures 2A-2D are flow diagrams illustrating an overview of the application of a machine learning model to detect anomalous cells in an electric battery system, according to some of the example embodiments presented herein. According to some of the example embodiments, the machine learning model may be an unsupervised model. In such embodiments, the model is trained on data recorded from normal cells. As a consequence, the machine learning model, as presented herein, is trained to predict the behaviour of a normal cell. Thus, in operation, the machine learning model is configured to detect when a cell deviates from the predicted normal cell behaviour and is thus an anomalous battery cell.

When training the machine learning model, a data set representing normal cell behaviour is used. The data set may be in the form of individual cell measurements as described in relation to Figure 1. According to some of the example embodiments presented herein, the training data set may be obtained according to different modes, such as an offline mode, an online mode, and a hybrid online/offline mode.

According to some embodiments, the training data set may be obtained in an online mode, thereby obtaining the training data from the respective CMDs within the electric battery system while in operation (Figures 2A-2B). In such embodiments, the machine learning model may be uniquely trained to the behaviour to the user of the electric battery system and captures the unique patterns and behaviours of the individual electric battery system more accurately. For example, for a user driving the vehicle in an urban setting, the electric vehicle may be driven with frequent stopping required. In such an example, the induvial battery cells are likely to degrade at a faster rate. As such, the normal cell behaviour as predicted by the machine learning model may be adjusted to consider such a use case.

The online training mode makes use of an assumption that the battery system is configured to operate normally within a predefined number of charging cycles. Specifically, batteries cells are typically tested prior to being implemented in an electrical vehicle, thus it is assumed the battery is functional and has not undergone degradation before a number of predetermined charging cycles during normal operating conditions. Therefore, the training, where the machine learning model trained to predict normal cell behaviour, may be configured to be performed within the predefined number of cycles. According to some of the example embodiments, in the training may be performed within the Battery Monitoring System (BMS) of the electric battery system.

In other example embodiments, the training data may be obtained in an offline mode and therefore obtained from a different battery system prior to a first use within the electric vehicle (Figures 2C-2D). In such embodiments, the different battery system may have a same configuration and cell type as the electric battery system being monitored. The pre-trained machine learning model may be implemented within the electric battery system, for example, within the BMS. In such embodiments, the machine learning model is fully trained, and anomaly detection may start from the first use of the electric battery system.

According to some of the example embodiments, the pre-trained machine learning model (e.g., obtained using an offline mode), or a model obtained via an online mode, may be updated during the operation of the electric vehicle to account for the normal cell behaviour adjusted to a specific use case while the model is being used for real-time anomaly detection (Figure 2B and 2D). In other example embodiments the machine learning model is not updated after having been implemented in the electric battery system (Figures 2A and 2C).

Figure 2A is a flow diagram depicting the use of a machine learning model for anomaly detection, where the machine learning model is trained online and not updated, according to some of the example embodiments presented herein. At step 211, cell-level data is collected from the electric battery system while in operation. The data may be in the form of cell-level measurements obtained from respective CMDs in the battery system. The data being collected may include at least one of a voltage, current, temperature or pressure for each of the cells comprising the battery pack.

At step 212, the data is pre-processed. Steps of pre-processing may include splitting the data set into a training data set and a validation data set. Steps of pre-processing may also include data normalisation, where data is scaled between 0 and 1. Pre-processing steps may also include dividing the data set into a plurality of smaller, fixed-sized data sets. Pre-processing steps may also include segmenting the data sets into a plurality of data sets based on the cell identification number (cell ID), creating individual data sets for each of the plurality of cells comprising the electric battery system.

At step 213, the machine learning model is trained online, based on data collected from the electric battery system being monitored. According to some of the example embodiments, the training may be performed for a predetermined number of battery charge cycles, where the battery system is expected to behave normally.

At step 214, after the training of the machine learning model was completed, real-time anomaly detection may start, using the trained machine learning model. Data may be recorded from the electric battery system while in operation, and inputted in the trained machine learning model, and anomalous cells may be flagged.

Figure 2B is a flow diagram depicting the use of a machine learning model for anomaly detection, where the machine learning model is trained online and updated. At step 226, after steps 211 through 214 are performed (as explained above in relation to Figure 2A), the machine learning model may be updated. Concurrently to using the trained machine learning model for real-time anomaly detection, the battery system (e.g., the BMS) may be configured to re-train the machine learning model. The updating of the machine learning model ensures that the anomaly detection remains effective and adapts to the changing behaviours of the cells. It allows the model to adapt to cell data drift, cell degradation and evolving operating conditions (e.g., associated with specific use cases), ensuring the anomalies are detected effectively throughout the life cycle of the battery pack.

Figure 2C is a flow diagram depicting the use of a machine learning model for anomaly detection, where the machine learning model is trained offline and not updated. At step 231, the machine learning model may be trained offline, using data collected from a different battery system comprising a same configuration and cell type as the electric battery system being monitored. The pre-trained machine learning model is then implemented in the battery system (e.g., the BMS) and may be used for immediate detection.

At step 232, real-time anomaly detection may start, using the pre-trained machine learning model. Data may be recorded from the electric battery system while in operation via respective CMDs. The recorded data may be inputted in the pre-trained machine learning model, and anomalous cells may be flagged from the output of the machine learning model.

Figure 2D is a flow diagram depicting the use of a machine learning model for anomaly detection, where the machine learning model is trained offline and updated. After steps 231 and 232 are performed, the model may be updated according to step 226 (as described in relation to Figure 2C). Following step 226, steps 211 through 213 may be performed (as described in relation to Figure 2A), leading to real-time anomaly detection with an updated machine learning model.

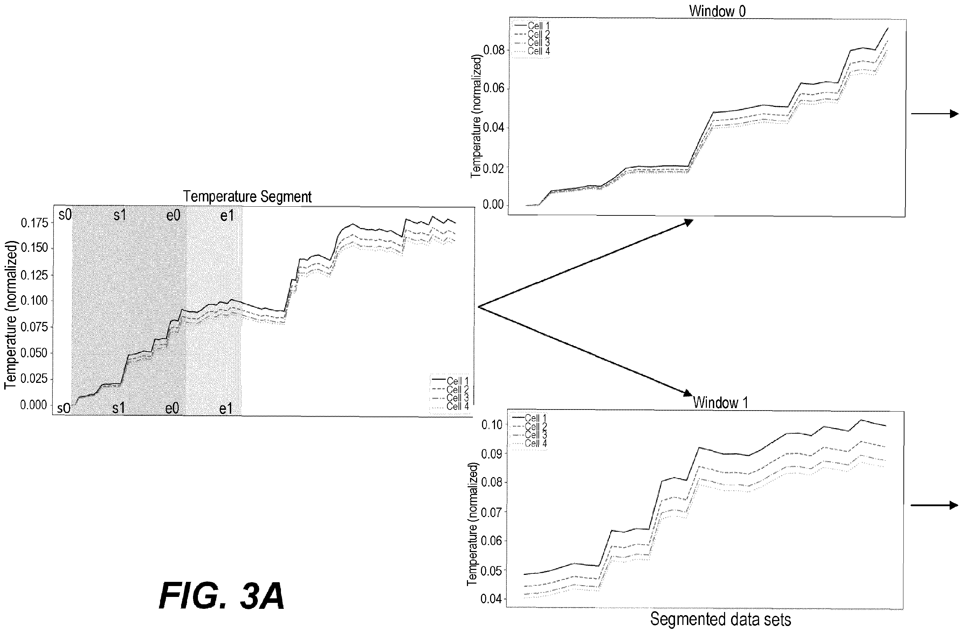

As described in relation to Figure 2A, according to some of the example embodiments, data preprocessing 212 may be employed to increase the effectiveness and efficiency of training the machine learning model and using the model for anomaly detection. Figures 3A-3B illustrate an example of data preprocessing in the form of sampling or windowing which includes the segmenting an initial data set (e.g., the obtained training data set) into a plurality of processed data sets based on timestamps and sampling the segmented data sets into a plurality of data sets based on a cells' identification (ID).

In the first graph of Figure 3A (left part), the temperature cell-level measurements of four different cells in the battery system is plotted over time (`Temperature Segment'). According to some of the example embodiments, the machine learning model is trained with fixed-size datasets, all containing the same number of data points. The size of these datasets is chosen to balance the need for a sufficient number of data points to train the model effectively and the need to use reasonable processing power for training. By using smaller data sets, the model can capture the localised patterns that may be difficult to learn from longer sequences like the entire cell time series.

The segmentation of the data set involves defining timestamps, each of the segmented data sets having a starting timestamp s and an ending timestamp e. A first data set is extracted, shown in `Window 0' (top right of Figure 3A), comprising all the data points between the starting timestamp *s₀* and the ending timestamp *e₀.* A second data set is extracted, shown in `Window 1' (bottom right of Figure 3A), comprising all the data points between the starting timestamp *s₁* and the ending timestamp *e₁.* This process is repeated for subsequent data sets until the entire data set is segmented.

According to some of the example embodiments, the starting timestamp of a segmented data set can be selected to create overlaps with other data sets. This means the same data points might appear in at least two different segmented data sets. For instance, the starting timestamp of one segmented data set may be later than the starting point but earlier than the ending point of a previous data set. The overlapping of data in the segmented data sets may be engineered to artificially increase the amount of data available for the training of the machine learning model. Additionally, the overlapping of data in the segmented data sets allows for the presentation of data in multiple contexts.

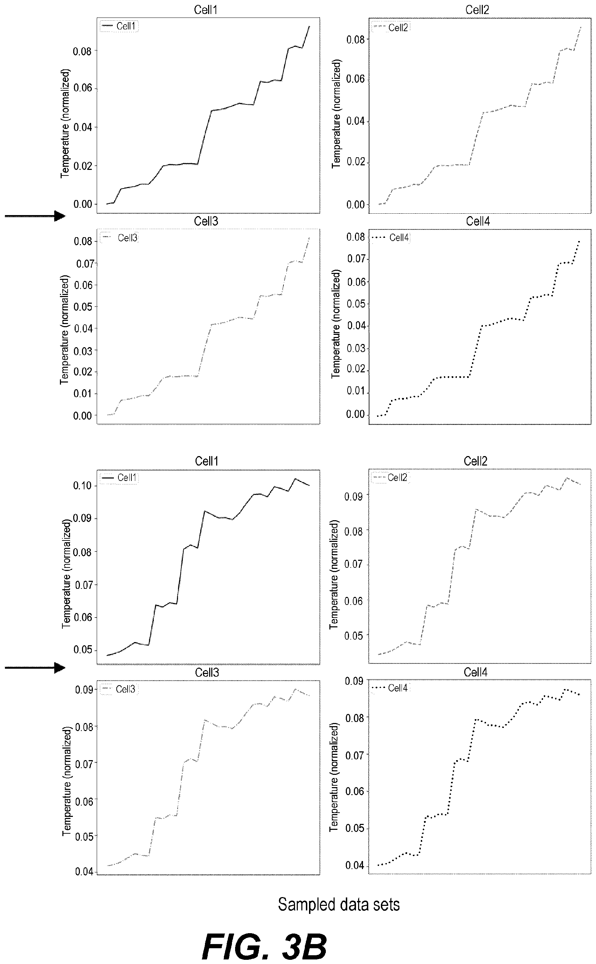

The segmentation of the received training data sets into a plurality of processed data sets is followed by the sampling of the processed data sets into a plurality of processed data sets based on the cells' ID, each of the cells comprising the electric battery system having its own data sets. In the example illustrated in Figure 3B, each processed data set (illustrated as Window 0 and Window 1) is sampled for each of the four cells (illustrated as Cell 1-Cell 4) as shown on the right of Figures 3A-3B.

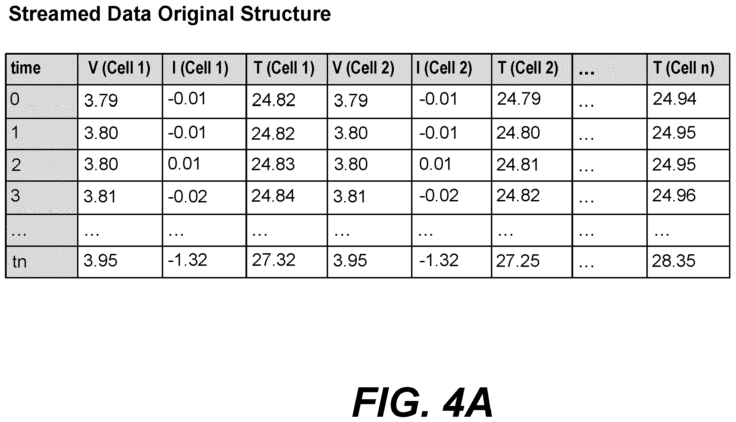

It should be appreciated a battery system may utilize a large number of individual battery cells. Therefore, overtime thousands of data points may be obtained within the processed data set. Figure 4A illustrates an example table used for recording data points for each cell within the electric battery system, including voltage (V), current (I) and temperature (T) cell-level measurements. As explained in Figure 3B, the data set is segmented and sampled based on the cells' ID. As shown in Figure 4A, the recorded data comprises a large amount of data points which are associated with respective individual cells. Retaining the information related to the cells' ID as part of the data inputted into the machine learning model is useful for capturing similarities and relationships between the cells, as well as ensuring the accuracy of the analysis.

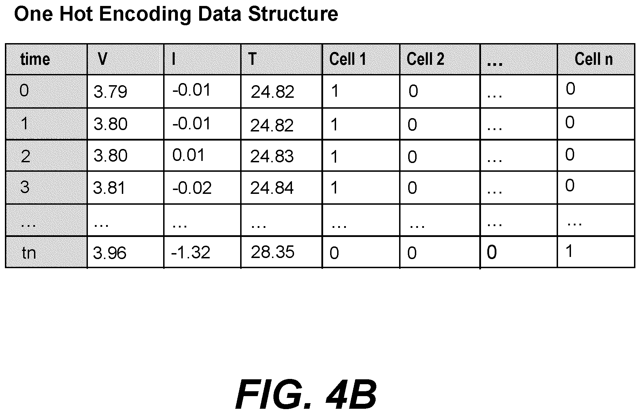

A need exists for simplifying data processing to allow for efficient data analysis. A solution known in the art to include the information relating to the cells' ID in the sampled data sets is using a One Hot Encoding data structure, illustrated in Figure 4B. However, this data structure creates a high-dimensional, sparse representation of the cell identification number which may be very computational inefficient and may not capture relationships between the cells effectively.

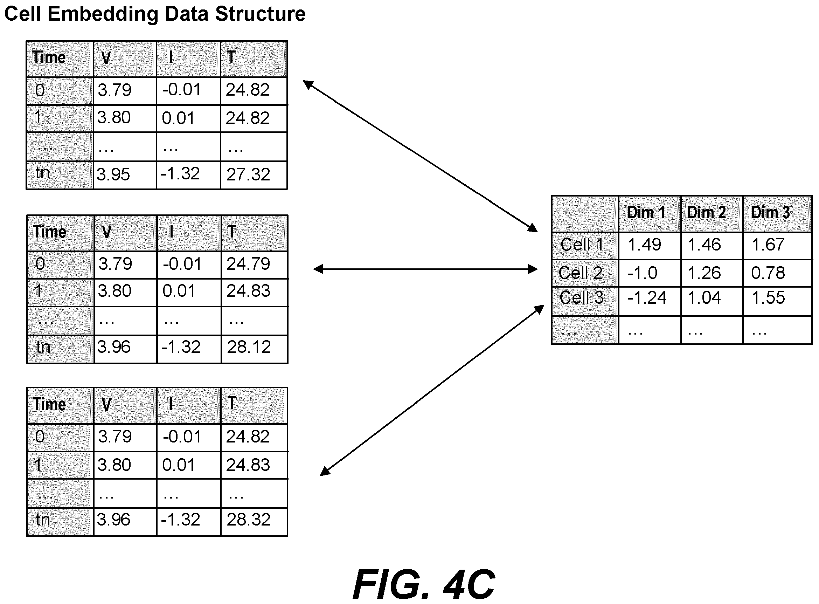

According to some of the example embodiments presented herein, an alternative to the One Hot Encoding structure of Figure 4B is utilized in the form of embedding vectors. Embeddings allow the model to map the categorical cell identification numbers to a low-dimensional vector space, capturing the similarities and relationships between the cells in an efficient manner. The embeddings in the model may be randomly initialised before training. During the training process, the model learns and updates the embeddings based on the patterns and relationships in the cell data. The embedding layer acts as a lookup table, where each unique cell ID is associated with a vector. When a cell ID is encountered during training through the sampled data sets, the embedding layer retrieves the corresponding embedding vector, and it combines it with the cell features. As the model is trained on the cell data, the embeddings are gradually adjusted to capture the similarities and relationships between the cells. Examples of such relationships may be cells in certain locations within the electric battery system being expected to degrade in a similar manner. For example, the battery cells situated in the middle of the battery pack may degrade at a similar and distinct rate as compared to battery cells situated towards the outer edges of the battery pack. Therefore, the battery cells within the middle of the battery pack may have a defined embedding relationship. The cell Embedding data structure is shown in Figure 4C.

The dimension of the embedding vectors refers to the number of components or features that make up each vector, and this dimension is determined prior to the start of the training process. In some example embodiments, illustrated in Figure 4C, the embedding vectors can have 3 components. In some other embodiments, the embedding vectors may have more than 3 components. In yet some other embodiments, the embedding vectors may have less than 3 components. The dimension of the embedding vectors is chosen to strike a balance between an accurate representation of the patterns and behaviours of the cells, and the computational cost associated to the embedding vectors.

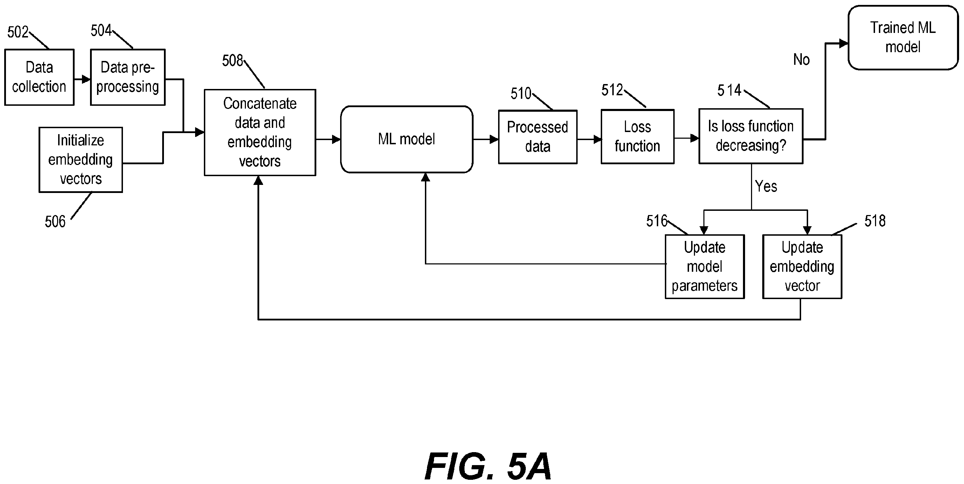

Figure 5A is an exemplary flow diagram of the training of the machine learning model, according to some of the example embodiments presented herein. In some example embodiments, the machine learning model is trained using the training split of the original data set, as described in relation to Figures 2A-2D and Figures 3A-3B. In some example embodiments, the training of the machine learning model may undergo several iterations of training. The training steps being repeated at each iteration of the training process are steps 508 to 514.

At step 502 the data used in the training of the machine learning model is collected. As explained in Figures 2A-2D, the data may be collected from a different electric battery system or from the electric battery system being monitored while in operation via offline, online or hybrid training modes.

At step 504 the data is pre-processed. As explained in Figures 2A-2D and Figures 3A-3B, the pre-processing of the data may include a splitting of the data into a training and validation data set, the normalization of the data and the segmentation and sampling of the data set into a plurality of data sets.

At step 506, concurrently to step 504, the embedding vectors may be initialized. In some example embodiments the embedding vectors can be randomly initialized, as explained in relation to Figure 4C.

At step 508, the sampled data and the embedding vectors are concatenated. For each cell, the sampled data sets are associated with the corresponding cell's embedding vector. The concatenated vectors are then input into the machine learning model.

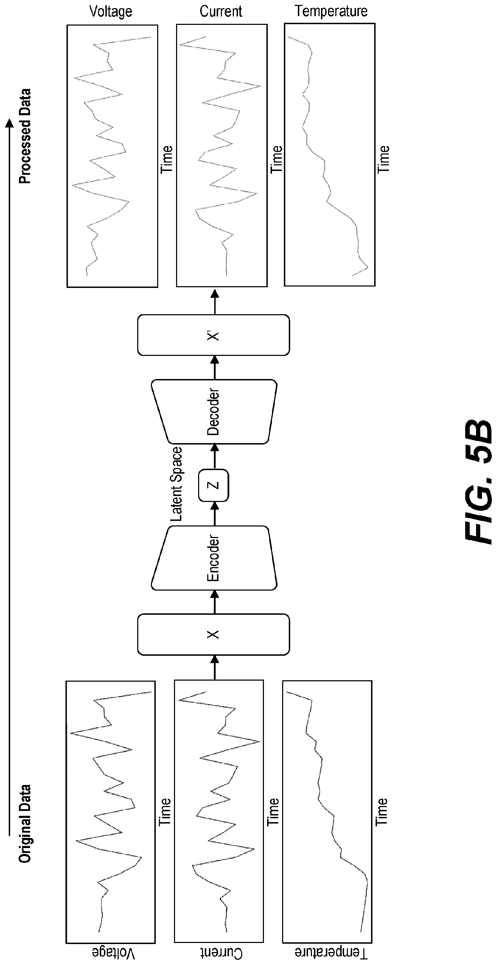

At step 510, the machine learning model outputs processed data sets. According to some of the example embodiments. The steps taken by the machine learning model are further detailed in Figure 5B. At step 512, a loss function is calculated. The loss function is representative of the difference between the input and the output data of the machine learning model. In some example embodiments, the error function is the Mean Squared Error. In such embodiments, the error value is initialized at 0, and at every time stamp, the difference between the input and output data value is calculated, squared, and added to the error value. Finally, the error value is divided by the number of time steps. In some other embodiments, the error function may be the Mean Absolut Error, R-Squared, the Mean Absolute Percentage Error, or any other loss function known in the art.

If the current iteration is the first iteration of the training process, the method skips steps 514 and goes directly to steps 516 and 518. If the current iteration is not the first, at step 514, the value or the error function is compared to the value of the previous iteration of the machine learning model. If the value of the error function has decreased compared to the previous iteration of the training, the model is still learning, and another training iteration may be necessary. The process goes to steps 516 and 518. If the value of the error function has increased compared to the previous iteration, the model is not learning anymore, and the machine learning model is considered trained, the training process ends.

According to some of the example embodiments, after the loss function has been calculated, the iteration of the training may be validated using a validation data set. The purpose of the validation data set is to test the machine learning model on unknown data. If the model performs well on the unknown data of the validation set, the model can continue training. If the model is no longer performing well on the unknown data of the validation set, the model is not learning anymore but rather has overfitted the data of the training set. In such cases, the training of the machine learning model may be interrupted.

At step 516, the model parameters are updated. The model parameters are modified in such a way that the model is better capable of reconstructing the input data sets. According to some of the example embodiments, the parameters of the model may include weights and biases. At each iteration, the gradient of the loss function may be calculated with respect to each of these parameters, and the parameters are updated in the opposite direction of the gradient. According to some of the example embodiments, the upgrading of the parameters of the model may follow a learning rate, wherein the learning rate by the amount by which each parameters can be modified after each iteration. The learning rate may vary during the training of the model. In such embodiments, the variation of the learning rate may reduce the time and computational power necessary to train the model. Big steps in the parameters updating may be done at the beginning of the learning process, and smaller steps may be done at the end of the training of the model.

At step 518, the embedding vectors' values are updated. The embedding vectors' values are modified to better represent the relationships between the cells comprising the electric battery system. According to some of the example embodiments, after each iteration of the training, the model may calculate how the value of the error function changes with respect to each embedding vector using backpropagation. In such embodiments, the model updates the embedding vectors to minimise this error.

According to some of the example embodiments, once the training process has resulted in the error function providing a minimum value, the model may be validated using the validation data set. The purpose of the validation data set is to test the machine learning model on unknown data. If the model is performing well on the unknown data of the validation data set, the model is properly trained. If the model is not performing well on the unknown data of the validation data set, the model has overfit the training data set and is not properly trained.

Figure 5B is a schematic representation of the machine learning model. According to some of the example embodiments, the machine learning model uses an encoder and a decoder to create the processed data sets. According to some of the example embodiments, the recorded and pre-processed data labelled as "Original" is input into the encoding space of the machine learning model "X". The data is then input into the encoder of the machine learning model. The encoder is responsible for compressing the input cell data into a lower-dimension representation. Through the iteration of the learning process, the encoder learns which information to retain and encode based on its relevance for reconstructing the original data. The compressed representation is represented by the Latent Space "Z". The Latent Space captures the features and patterns of the cell data in a lower-dimensional space. The latent space is then input into a decoder, which is responsible for reconstructing the original input data from the latent representation. The purpose of the decoder is to learn to generate an output data set that closely resembles the input data set, which is the normal behaviour of the cell data. The output data finally goes through the decoding space "X"', which outputs the "Processed data".

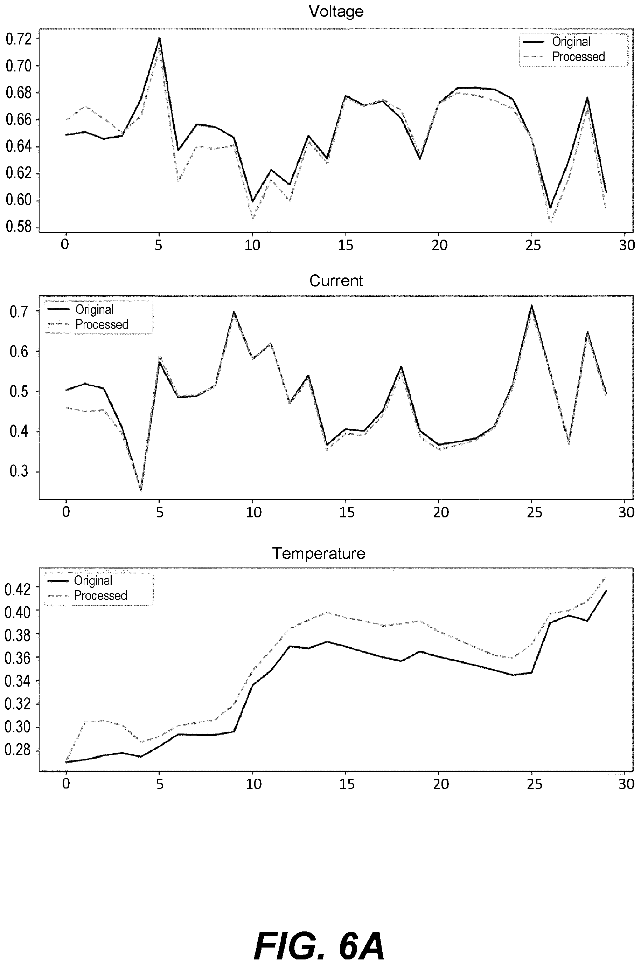

Figure 6A illustrates an example time-series plot of the input and the output of the machine learning model for an individual battery cell operating under normal conditions, according to the example embodiments presented herein. The recorded and pre-processed data labelled as "Original" (depicted as a solid line in Figure 6A) is input into the machine learning model. The "Processed" data (depicted as a dashed line in Figure 6A) is the output of the machine learning model. For a normal cell, the original and the processed lines comprise similar values, therefore, the loss function will yield a minimal value and the trained model is able to predict the normal behaviour of the cell.

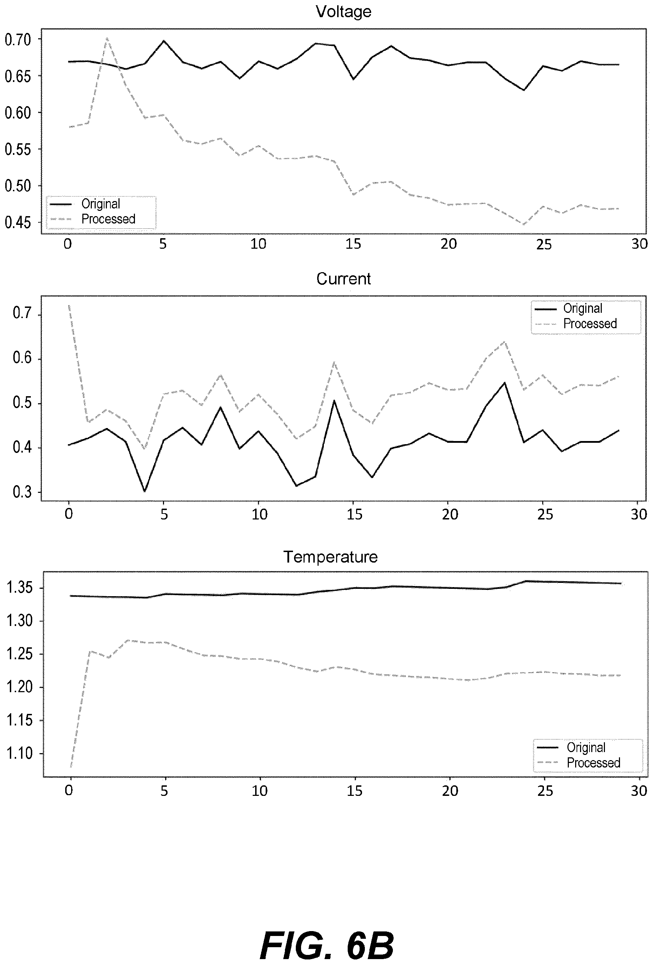

Figure 6B illustrates an example time-series plot of the input and the output of the trained machine learning model upon the detection of an anomalous battery cell. The recorded and pre-processed data labelled as "Original" (depicted as a solid line in Figure 6B) is input into the model. The "Processed" data (depicted as a dashed line in Figure 6B) is the output of the trained machine learning model. For an anomalous cell, the model is not able to predict the behaviour of the cell, because it has been trained on data associated with normal battery cells. Therefore, the trained machine learning model predicts the behaviour of the battery cell operating under normal conditions. Here, the original and processed lines don't follow the same trend, especially for the voltage signal and the temperature signal. For the current signal, the original and processed lines follow the same trend but with a shift in value. Thus, from Figure 6B, the battery system is able to detect a fault in the monitored battery associated with voltage.

As a consequence, and as seen on Figures 6A-6B, the error function would have a smaller value for the normal cell than for an anomalous cell, where the error function is representative of the difference between the input (Original data set) and the output (Processed data set) of the machine learning model. Thus, upon detecting a value of an error function is above a predetermined threshold, the cell associated with the error function may be flagged as being anomalous.

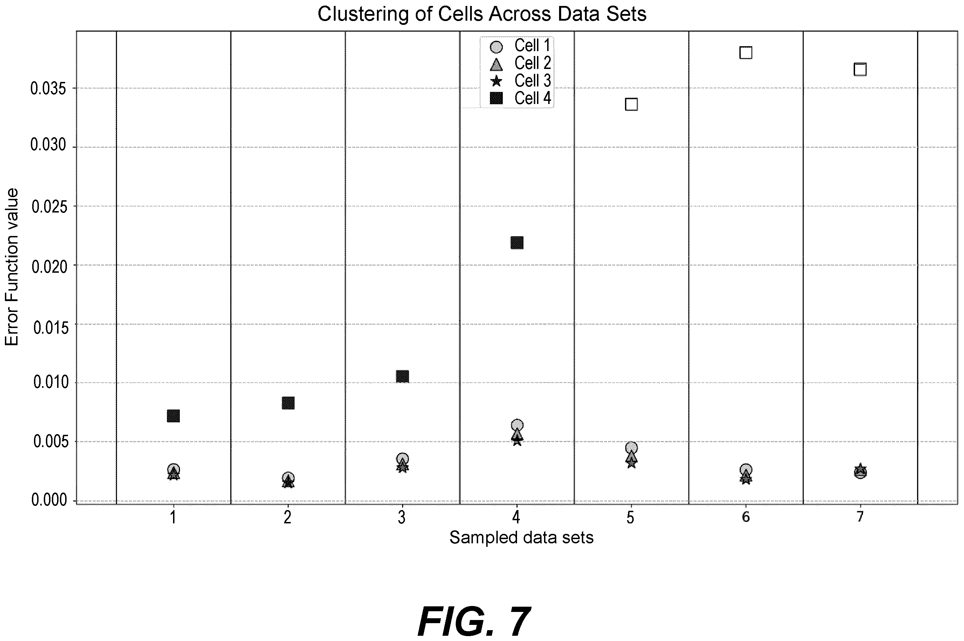

Figure 7 illustrates an example representation of the clustering method for anomaly detection. According to some of the example embodiments, for each of the sampled data sets (representing a time window, as illustrated in Figures 3A-3B), a mean value of the error function may be calculated for each of the battery cells. In the example illustrated in Figure 7, a mean value of the error function is calculated for each sampled data set (Data sets 1 to 7), for each of the battery cells (Cell 1 to Cell 4).

According to some of the example embodiments, a battery cell may be considered anomalous if the mean value of its error function is flagged as outside of a cluster for a preset number of sampled data sets. In such embodiments, a data point is flagged as outside of a cluster if its distance to its closer neighbours is larger than a predetermined value.

According to some of the example embodiments, the preset number of data sets for which a cell must be outside of a cluster to be considered anomalous can be chosen to accurately detect anomalous cells while allowing for localized and limited out-of-the-ordinary behaviour. In some example embodiments, a battery cell may deviate from its normal behaviour for a limited time period without being considered an anomaly. In other embodiments, the data recorded by the processing unit may be temporarily noisy or faulty. In other embodiments, the battery cell may deviate from its normal behaviour during certain phases of a charge or discharge or rest cycle without being consider an anomaly. In such cases, a battery cell should not be considered anomalous.

According to some of the example embodiments, the predetermined distance between data points required for them to be considered within or outside of a cluster can be selected to balance model flexibility and accuracy in detecting anomalous battery cells. A small threshold distance assumes that the model maintains high performance in reconstructing normal data throughout the entire usage period. In such cases, a cell with a slightly higher error function value might be flagged as anomalous, even if it is just due to an evolution in the cell's behaviour and the model's decreasing accuracy. Conversely, a large threshold distance could result in numerous false negatives, where a false negative is an anomalous cell considered normal. According to some of the example embodiments, a cell flagged as outside of a cluster may be represented with an unfilled symbol, such as cell 4 in data sets 5 through 7 in Figure 7.

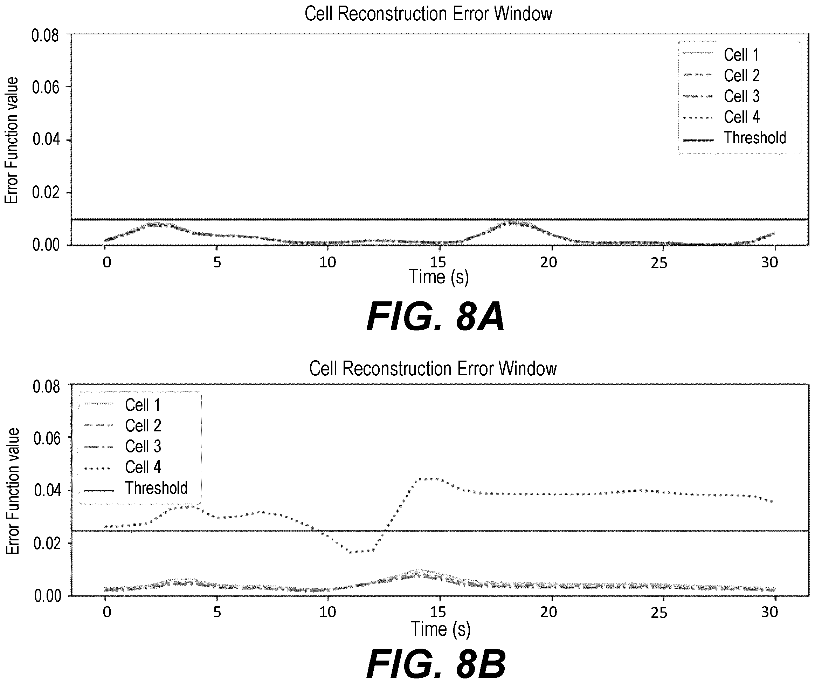

Figure 8A illustrates an example representation of the dynamic threshold method for anomaly detection for battery cells operating under normal conditions, according to the example embodiments presented herein. Figure 8B illustrates an example representation of the dynamic threshold method for anomaly detection for battery cells, where some cells are operating under normal conditions, and one cell is an anomaly, according to the example embodiments presented herein.

According to some of the example embodiments, for a specific sampled data set, the error function is plotted against time for four different battery cells (Cell 1 to Cell 4). The mean value of all the error functions is calculated, along with the standard deviation of the error function across all cells. A threshold is then defined as the sum of the mean value and a preset multiplier of the standard deviation.

For normal cells, the error function value should stay below the threshold for at least a predetermined fraction of the duration of the sampled data set. For a cell to be considered an anomaly, the error function value should be above the threshold value for more than a predetermined fraction of the duration of the sampled data set.

According to some of the example embodiments, the preset multiplier may be chosen to strike a balance between falsely identifying normal cells as anomalous (False Positive) and falsely identifying anomalous cells as normal cells (False Negative). According to some of the example embodiments, the predefined multiplier may be chosen to prefer the occurrence of False Positive over the occurrence of False Positive as failing to identify an anomalous cell may be more detrimental to the overall performance of the electric battery system.

According to some of the example embodiments, the predetermined fraction of the duration of the sampled data set for which a cell's error function must be above the threshold to be considered anomalous can be chosen to accurately detect anomalous cells while allowing for localized and limited out-of-the-ordinary behaviour. In some example embodiments, a battery cell may deviate from its normal behaviour for a limited time period without being considered an anomaly. In other embodiments, the data recorded by the processing unit may be temporarily noisy or faulty. In such cases, a battery cell should not be considered anomalous.

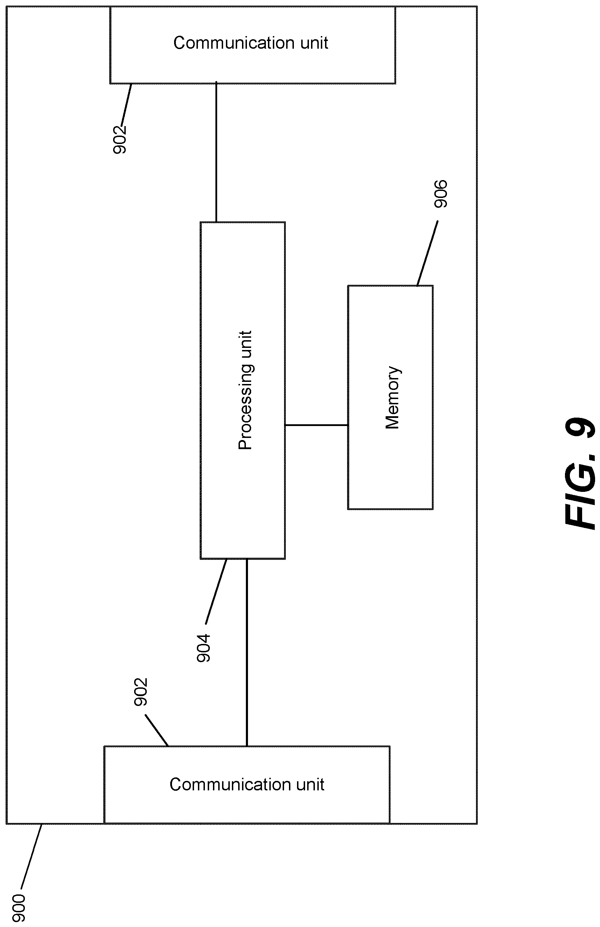

Figure 9 illustrates an example node configuration of a computational unit 900 which may be in the form of a training unit and/or a monitoring unit configured perform some of the example embodiments described herein. The computational unit 900 may comprise radio circuitry or a communication unit 902 that may be configured to receive and/or transmit communication data, instructions, and/or messages. It should be appreciated that the radio circuitry or communication unit 902 may be comprised as any number of transceving, receiving, and/or transmitting units or circuitry, it should further be appreciated that the radio circuitry or communication unit 902 may be in the form of any Input or output communications port known in the art. The radio circuitry or communication unit 902 may comprise RF circuitry and baseband processing circuitry (not shown).

The computational unit 900 may also comprise a processing unit or circuitry 904 which may be configured to train a machine learning model as described herein. The processing unit or circuitry 904 may also be configured to monitor cell behaviour with use of a machine learning model as described herein.

The processing circuitry 904 may be any suitable type of computation unit, for example, a microprocessor, digital signal processor (DSP), field programmable gate array (FPGA), or application specific Integrated circuit (ASIC), or any other form of circuitry. The computational unit 900 may further comprise a memory unit or circuitry 906 which may be any suitable type of computer readable memory and may be of volatile and/or non-volatile type. The memory 906 may be configured to store received, transmitted, and/or measured data, device parameters, communication priorities, and/or executable program instructions.

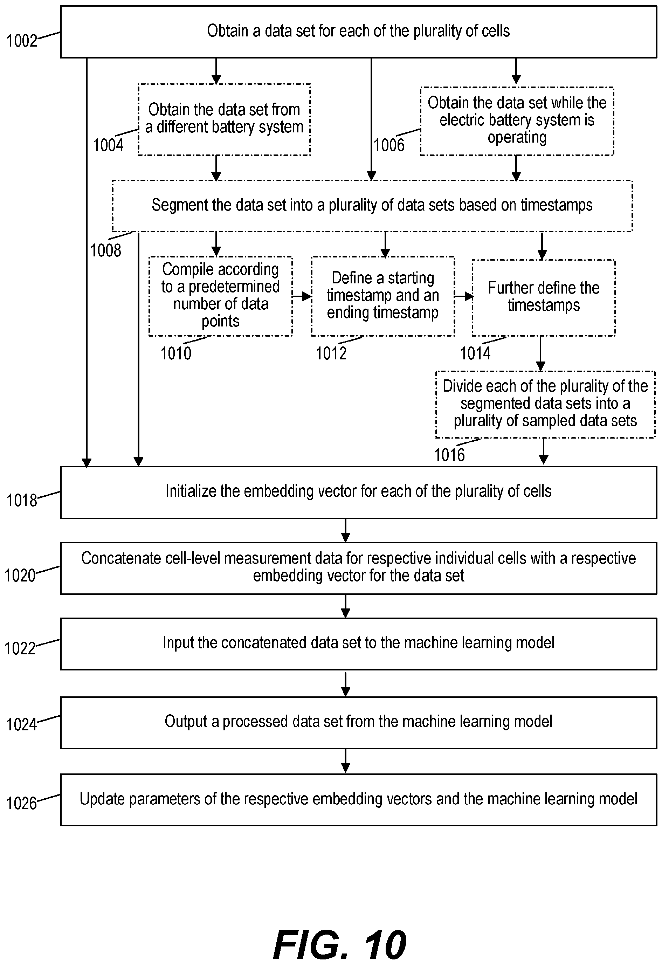

Figure 10 is a flow diagram depicting example operations which may be taken by the computational unit (e.g., a training unit) of Figure 9 as described herein in providing machine learning model training for monitoring of cells in a battery pack. It should be appreciated that Figure 10 comprises some operations which are illustrated with a solid border and some operations which are illustrated with a dashed border. The operations which are comprised in a solid border are operations which are comprised in the broadest example embodiments. The operations which are comprised in the dashed border are example embodiments which may be comprised in, or a part of, or are further operations which may be taken in addition to the operations of the broader example embodiments. It should also be appreciated that the actions may be performed in any order and any combination.

### Operation 1002

The example embodiments comprise obtaining 1002, a data set comprising at least one of a cell-level voltage measurement (V), a cell-level current measurement (I), or a cell-level temperature measurement (T) for each of the plurality of cells. The communications unit 902 of the training unit (e.g., computational unit) is configured to obtain the data set.

The obtained data set is used in training a machine learning model. According to some of the example embodiments, the machine learning model may be in the form of Standard Recurrent Neural Network (RNN), a Gated Recurrent Unit, a bidirectional Recurrent Neural Network, a bidirectional Long Short-Term Memory (LSTM), a Temporal Convolution Network or Transformers. According to some of the example embodiments, the machine learning model is configured to predict a behaviour of normal cell operation.

### Example operation 1004

According to some of the example embodiments, the obtaining 1002 further comprises obtaining 1004 the plurality of at least one of the voltage, current, temperature or pressure cell-level measurement for each of the plurality of cells from a different battery system having a same configuration and cell type as the electric battery system being monitored, where the training of the model is performed offline and prior to a use of the electric battery system. The communications unit 902 is configured to obtain the plurality of measurements from the different battery system.

As explained in conjunction with Figures 2C and 2D, according to some of the example embodiments, the training of the machine learning model may be performed offline. In such embodiments, the machine learning model is fully trained at a first use of the electric battery system, as the training was performed using previously obtained data from a different battery system.

### Example operation 1006

According to some of the example embodiments, the obtaining 1002 may further comprise obtaining 1006, the plurality of at least one of the voltage, current, temperature or pressure cell-level measurement for each of the plurality of cells while the electric battery system is operating, starting from the first use of the electric battery system, until a predetermined number of charging cycles of the electric battery system is reached. In such embodiments, the training of the model is performed online and the machine learning model is configured to predict the behaviour of normal cell operation according to an actual use of the electronic battery system. The communications unit 902 is configured to obtain the plurality of measurements during a user of the electric battery system. As explained in conjunction with Figures 2A and 2B, according to some of the example embodiments, the training of the machine learning model may be performed online. In such embodiments, the training of the machine learning model may be adapted to a specific use case. Specifically, the machine learning model, which is configured to predict normal cell behaviour, will be trained according to how the electric vehicle is driven, as explained in accordance with Figure 2A. According to some of the example embodiments, the data set comprising at least one of the voltage, current, temperature or pressure cell-level measurement for each of the plurality of cells can include a preset number of charging cycles of the electric battery system. According to some of the example embodiments, the preset number of charging cycles of the electric battery system can be at least 1 to approximately 250.

According to some of the example embodiments, the data set comprising at least one of the voltage, current, temperature or pressure cell-level measurement for each of the plurality of cells can including a preset number of charging cycles of the electric battery system can include data starting from the first use of the electric battery system. According to some of the example embodiments, the cells of the electric battery system are assumed to have a behaviour of normal cell operation during the preset number of charging cycles of the electric battery system.

### Example operation 1008

Some of the example embodiments further comprise segmenting 1008 the data set into a plurality of data sets based on timestamps. The processing unit 904 of the training unit (e.g., computational unit) is configured to segment the data set. An example of data segmentation is illustrated in Figures 3A-3B.

### Example operation 1010

According to some of the example embodiments, the segmentation 1008 of the data set further comprises compiling 1010 each of the plurality of data sets to include a predetermined number of data points. The processing unit 904 is configured to compile each of the plurality of data sets to include a predetermined number of data points. According to some of the example embodiments, the predetermined number of data points may be chosen to strike a balance between having a sufficient number of data points to train the model and using a reasonable processing power to train the model.

### Example operation 1012

Upon the compiling 1010, some of the example embodiments may further comprise defining 1012 each of the plurality of data sets to comprise a starting timestamp and an ending timestamp, as illustrated in Figure 3A. The processing unit 904 is configured to define each of the plurality of data sets.

### Example operation 1014

Upon the defining 1012, some of the example embodiments may further comprise further defining 1014 the starting timestamp of each of the plurality of data sets to be greater than the starting timestamp of a previous data set and wherein said respective starting time is smaller or equal to the ending timestamp of the previous data set, as illustrated in Figure 3B. The processing unit 904 is configured to further define the starting timestamp.

It should be appreciated, defining a starting timestamp of a data set smaller than the ending timestamp of the previous data set may create overlap in the data sets, resulting in the same data points appearing in multiple datasets. The overlap in the data sets may be engineered to allow for the presentation of data in multiple contexts. The overlap in the data sets may also provide an artificially increase in the amount of data available to train the machine learning model. Thus, according to some of the example embodiments, such an overlap may be useful in increasing the robustness of the machine learning training and prediction.

### Example operation 1016

Upon the further defining 1014, some of the example embodiments may comprise dividing 1016 each of the plurality of the segmented data sets into a plurality of sampled data sets based on each of the plurality of cell identification numbers, where dividing a data set based on cell identification numbers includes creating a data set for each of the plurality of cells, as illustrated in Figure 3B. The processing unit 904 of the training unit (e.g., computational unit) is configured to divide the segmented data set.

### Operation 1018

The example embodiments further comprise initializing 1018 an embedding vector for each of the plurality of cells. The processing unit 904 of the training unit (e.g., computational unit) is configured to initialize the embedding vectors. According to some of the example embodiments, the embedding vector may be associated with the corresponding cell identification number in a lookup table, as explained in conjunction with Figure 4C. The embedding vector may have a preset dimension, where the dimension of the embedding vectors refers to the number of components or features that make up each vector. Thus, the initialization of the embedding vector may be assigning the present dimensions to the embedding vector.

### Operation 1020

The example embodiments further comprise concatenating 1020 cell-level measurement data for respective individual cells with a respective embedding vector for the data set. The processing unit 904 of the training unit (e.g., computational unit) is configured to concatenate the embedding vectors to the corresponding data sets.

In some example embodiments, the embedding vector are concatenated to the corresponding sampled data sets, wherein a sampled data set may be obtained by dividing each of the plurality of the segmented data sets into a plurality of sampled data sets based on each of the plurality of cell identification numbers, wherein a segmented data set may be obtained by dividing a data set based on timestamps, as illustrated in Figures 3A-3B.

### Operation 1022

The example embodiments further comprise inputting 1022 the concatenated data of the data set to the machine learning model. The processing unit 904 of the training unit (e.g., computational unit) is configured to input the concatenated data to the machine learning model. Examples of data sets being input into the machine learning model are illustrated in solid line in Figures 7A and 7B (labelled as "Original"). According to some of the example embodiments, the sampled data sets may be used for the concatenating, as described in example operations 1010-1016.

### Operation 1024

The example embodiments further comprise outputting 1024 a processed data set from the machine learning model. The processing unit 904 of the training unit (e.g., computational unit) is configured to output the processed data set from the machine learning model. Examples of data sets being outputted from the machine learning model are illustrated in dashed line in Figures 6A and 6B (labelled as "Processed"). As illustrated in Figure 6A and 6B, the machine learning model may be able to accurately predict the input for normal cell but unable to accurately predict the data for anomalous cells.

### Operation 1026

The example embodiments further comprise updating 1026 parameters of the respective embedding vectors and the machine learning model at each iteration of the training of the machine learning model based on minimizing a loss function, where the loss function is based on a comparison of the data set and the processed data set. The processing unit 904 of the training unit (e.g., computational unit) is configured to update parameters of the respective embedding vectors and the machine learning model.

Upon the iteration of the training of the machine learning model the respective embedding vectors define relationships between individual cells which are expected to perform in a similar manner and a numerical representation to identify each cell in a vector space used for evaluating cell behaviour. According to some of the example embodiments, the loss function may include at least one of Mean Squared Error (MSE), Mean Absolute Error (MAE), R-Squared (R²), Mean Absolute Percentage Error (MAPE).

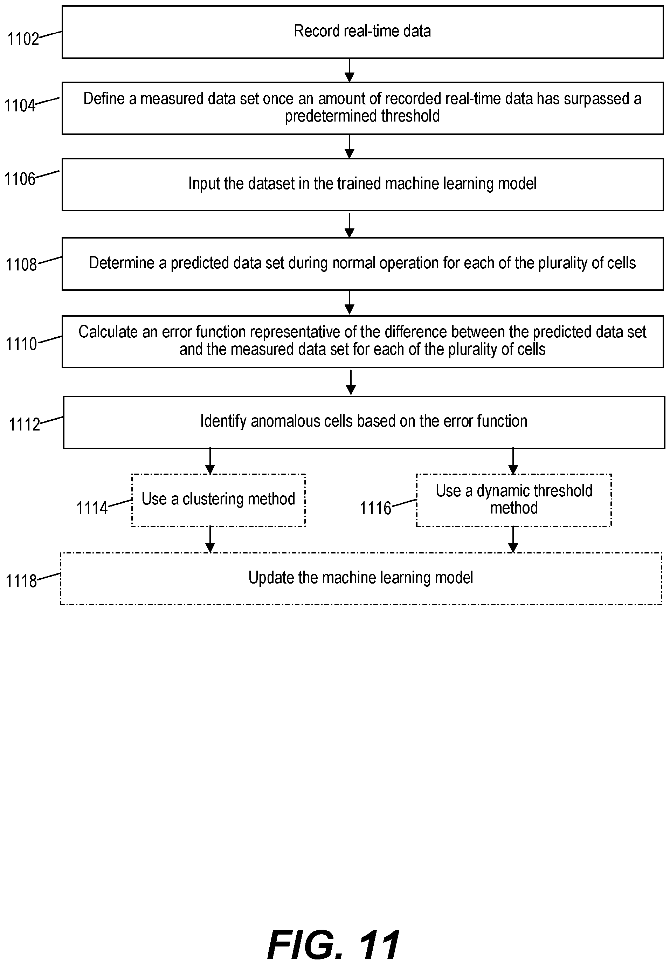

Figure 11 is a flow diagram depicting example operations which may be taken by the computational unit (e.g., monitoring unit) of Figure 11 as described herein in detecting anomalous behaviour of cells in an electric battery system using a machine learning model which is trained as explained in at least Figure 10. It should be appreciated that Figure 11 comprises some operations which are illustrated with a solid border and some operations which are illustrated with a dashed border. The operations which are comprised in a solid border are operations which are comprised in the broadest example embodiments. The operations which are comprised in the dashed border are example embodiments which may be comprised in, or a part of, or are further operations which may be taken in addition to the operations of the broader example embodiments. It should also be appreciated that the actions may be performed in any order and any combination.

### Operation 1102

The example embodiments comprise recording 1102 real-time data comprising a plurality of at least one of a voltage, current, temperature or pressure cell-level measurement for each of the plurality of cells while the electric battery system is operating. The processing unit 904 of the monitoring unit (e.g., computational unit) is configured to record the real-time cell-level data. The real-time cell-level data may be obtained via a CMD as described in relation to at least Figure 1.

### Operation 1104

The example embodiments further comprise defining 1104 a measured data set once an amount of recorded real-time data has surpassed a predetermined threshold. The processing unit 904 of the training unit (e.g., computational unit) is configured to define a measured data set. According to some of the example embodiments, the threshold for the amount of real-time data may be chosen to strike a balance between having a sufficient number of data points to train the model and using a reasonable processing power to train the model.

### Operation 1106

The example embodiments further comprise inputting 1106 the data set in the trained machine learning model. The processing unit 904 of the training unit (e.g., computational unit) is configured to input the data set in the trained machine learning model.

### Operation 1108

According to some of the example embodiments, inputting 1106 of the data set in the trained machine learning model may further comprise determining 1108 a predicted data set, where the predicted data set defines at least one of a voltage, current, temperature or pressure cell-level measurement for each of the plurality of cells during normal operation for each of the plurality of cells. The processing unit 904 of the training unit (e.g., computational unit) is configured to determine the predicted data set.

### Operation 1110

According to some of the example embodiments, inputting 1106 the data set in the trained machine learning model further comprises calculating 1110 an error function, where the error function is representative of the difference between the predicted data set and the measured data set for each of the plurality of cells. The processing unit 904 of the training unit (e.g., computational unit) is configured to calculate the error function. According to some of the example embodiments, the loss function may include at least one of Mean Squared Error (MSE), Mean Absolute Error (MAE), R-Squared (R²), Mean Absolute Percentage Error (MAPE).

### Operation 1112

The example embodiments further comprise identifying 1114 anomalous cells based on the error function. The processing unit 904 is configured to identify the anomalous cells based on the error function. The detection of the anomalous cells are described further in at least Figures 6-8.

### Example operation 1114

According to some of the example embodiments, the identification 1112 of anomalous cells further comprises using 1114 a clustering method, where the clustering method includes at least one of Density-Based Spatial Clustering of Applications with Noise, or K-means. According to some of the example embodiments, the clustering method 1114 may further comprise calculating a mean value of the error function of each of the segmented data sets.
According to some of the example embodiments, using a clustering method may comprise placing the mean value of the error function of each cell on a one-dimensional axis.

According to some of the example embodiments, using a clustering method may further comprise calculating the absolute distance between each cell's error function value and the nearest error function values on the one-dimensional axis. According to some of the example embodiments, using a clustering method may further comprise defining clusters of error function values, where a cluster is identified as a group of error function values with each having a distance to its nearest error function value neighbours that is less than a predetermined critical distance.

According to some of the example embodiments, the critical distance used to consider a data point in or out of a cluster may be determined based on the distribution of error function values in expected outputs of normal cell operation data. According to some of the example embodiments, using a clustering method may further comprise flagging a cell as anomalous if the cell is not in a cluster. The processing unit 904 may be configured to perform the above-mentioned operations.

### Example operation 1116

According to some of the example embodiments, the identification 1112 of anomalous cells further comprise using 1114 a dynamic threshold method. According to some of the example embodiments, using a dynamic threshold for anomalous cell identification may further comprise calculating a mean value of the error function of each of the segmented data sets.

According to some of the example embodiments, using a dynamic threshold for anomalous cell identification may further comprise calculating a standard deviation of the error function of each of the segmented data sets. According to some of the example embodiments, using a dynamic threshold for anomalous cell identification may further comprise defining a dynamic threshold, wherein the dynamic threshold is a sum of a predefined multiplier of the standard deviation and the mean value.

According to some of the example embodiments, the predefined multiplier may be chosen to strike a balance between falsely identifying normal cells as anomalous (False Positive) and falsely identifying anomalous cells as normal cells (False Negative). According to some of the example embodiments, the predefined multiplier may be chosen to prefer the occurrence of False Positive over the occurrence of False Positive as failing to identify an anomalous cell may be more detrimental to the overall performance of the electric battery system.

According to some of the example embodiments, using a dynamic threshold for anomalous cell identification may further comprise flagging a cell as anomalous if the error function is equal or greater than the dynamic threshold for a predefined fraction of the duration of the dataset. According to some of the example embodiments the predefined fraction of the duration of the data set multiplier may be chosen to strike a balance between False Positives and False Negatives. According to some of the example embodiments, the processing unit 904 is configured to perform the above-mentioned operations.

### Example operation 1118

The example embodiments may further comprise updating 1118 the machine learning model after a preset use time of the electric battery system is reached. According to some of the example embodiments, the preset time of the electric battery may be chosen based on the use of the electric battery system.

According to some of the example embodiments, if the electric battery system is cautiously or rarely used, the performance of the cells comprised in the electric battery system may decay slowly. In such embodiments, the machine learning model might not need updating for a long time.

According to some of the example embodiments, if the electric battery system is used in harder conditions the performance of the cells comprised in the electric battery system may decay more rapidly. In such embodiments, the machine learning model might need updating after a shorter number of charging cycles. The model may be updated when the battery system has undergone additional testing to determine its state. According to some of the example embodiments, the processing unit 904 may be configured to perform the above-mentioned operations.

The description of the example embodiments provided herein have been presented for purposes of illustration. The description is not intended to be exhaustive or to limit example embodiments to the precise form disclosed, and modifications and variations are possible in light of the above teachings or may be acquired from practice of various alternatives or equivalents to the provided embodiments. The examples discussed herein were chosen and described in order to explain the principles and the nature of various example embodiments and its practical application to enable one skilled in the art to utilize the example embodiments in various manners and with various modifications as are suited to the particular use contemplated. The features of the embodiments described herein may be combined in all possible combinations of methods, apparatus, modules, systems, and computer program products. It should be appreciated that the example embodiments presented herein may be practiced in any combination with each other.

It should be noted that the word "comprising" does not necessarily exclude the presence of other elements or steps than those listed and the words "a" or "an" preceding an element do not exclude the presence of a plurality of such elements. It should further be noted that any reference signs do not limit the scope of the claims, that the example embodiments may be implemented at least in part by means of both hardware and software, and that several "means", "units" or "devices" may be represented by the same or functionally equivalent item of hardware.

The various example embodiments described herein are described in the general context of method steps or processes, which may be implemented in one aspect by a computer program product, embodied in a computer-readable medium or a non-transitory computer-readable medium, comprising computer-executable instructions, such as program code, executed by computers or one or more processors in networked environments. A computer-readable medium or a non-transitory computer readable medium may comprise removable and non-removable storage devices comprising, but not limited to, Read Only Memory (ROM), Random Access Memory (RAM), compact discs (CDs), digital versatile discs (DVD), flash memories, etc. Generally, program modules may comprise routines, programs, objects, components, data structures, etc. that perform particular tasks or implement particular abstract data types. Computer-executable instructions, associated data structures, and program modules represent examples of program code for executing steps of the methods disclosed herein. The particular sequence of such executable instructions or associated data structures represents examples of corresponding acts for implementing the functions described in such steps or processes.

In the drawings and specification, there have been disclosed example embodiments. However, many variations and modifications can be made to these embodiments. Accordingly, although specific terms are employed, they are used in a generic and descriptive sense only and not for purposes of limitation, the scope of the embodiments being defined by the following claims.

## Claims

1. A method of training a machine learning model for monitoring an electric battery system, wherein the electric battery system comprises at least one pack, each pack comprising a plurality of individual cells, the method comprising:
obtaining a data set comprising a plurality of at least one of a voltage, current, temperature or pressure cell-level measurement for each of the plurality of cells;
initializing an embedding vector for each of the plurality of cells;
concatenating cell-level measurement data for respective individual cells with a respective embedding vector for the data set;
inputting the concatenated data of the data set to the machine learning model;
outputting a processed data set from the machine learning model; and
updating parameters of the respective embedding vectors and the machine learning model at each iteration of the training of the machine learning model based on minimizing a loss function, wherein the loss function is based on a comparison of the data set and the processed data set;
wherein upon the iteration the respective embedding vectors define relationships between individual cells which are expected to perform in a similar manner and a numerical representation to identify each cell in a vector space used for evaluating cell behaviour; and
wherein the machine learning model is configured to predict a behaviour of normal cell operation.

2. The method of claim 1, wherein obtaining the data set further comprises obtaining the plurality of at least one of the voltage, current, temperature or pressure cell-level measurement for each of the plurality of cells from a different battery system having a same configuration and cell type as the electric battery system being monitored, wherein the training of the model is performed offline and prior to a use of the electric battery system.

3. The method of claim 1, wherein obtaining the data set further comprises obtaining the plurality of at least one of the voltage, current, temperature or pressure cell-level measurement for each of the plurality of cells while the electric battery system is operating, starting from the first use of the electric battery system, until a predetermined number of charging cycles of the electric battery system is reached, wherein the training of the model is performed online and wherein the machine learning model is configured to predict the behaviour of normal cell operation according to an actual use of the electronic battery system.

4. The method of any of claims 1-3, wherein obtaining data set further comprises:
segmenting the data set into a plurality of data sets based on timestamps, wherein the segmenting further comprises:
compiling each of the plurality of data sets to include a predetermined number of data points;
defining each of the plurality of data sets to comprise a starting timestamp and an ending timestamp; and,
further defining the starting timestamp of each of the plurality of data sets to be greater than the starting timestamp of a previous data set and wherein said respective starting time is smaller or equal to the ending timestamp of the previous data set;
dividing each of the plurality of the segmented data sets into a plurality of sampled data sets based on each of the plurality of cell identification numbers, wherein dividing a data set based on cell identification numbers includes creating a data set for each of the plurality of cells; and
wherein concatenated data is provided with the sampled data sets.

5. The method of any of claims 1-4, wherein the machine learning model includes at least one of a Standard Recurrent Neural Network, RNN, a Gated Recurrent Unit, a bidirectional Recurrent Neural Network, a bidirectional Long Short-Term Memory, LSTM, a Temporal Convolution Network or Transformers.

6. The method of any of claims 1-5, wherein the loss function includes at least one of Mean Squared Error, Mean Absolute Error, R-Squared, Mean Absolute Percentage Error.

7. A training unit for training a machine learning model for monitoring an electric battery system, wherein the electric battery system comprises at least one pack, each pack comprising a plurality of individual cells, the training unit comprising:
a receiving unit configured to obtain a data set comprising a plurality of at least one of a voltage, current, temperature or pressure cell-level measurement for each of the plurality of cells;
a processing unit configured to initialize an embedding vector for each of the plurality of cells;
the processing unit further configured to concatenate cell-level measurement data for respective individual cells with a respective embedding vector for the data set;
the processing unit configured to input the concatenated data of the data set to the machine learning model;
the processing unit configured to receive processed data set as output from the machine learning model; and
the processing unit further configured to update parameters of the respective embedding vectors and the machine learning model at each iteration of the training of the machine learning model based on minimizing a loss function, wherein the loss function is based on a comparison of the data set and the processed data set;
wherein upon the iteration the respective embedding vectors define relationships between individual cells which are expected to perform in a similar manner and a numerical representation to identify each cell in a vector space used for evaluating cell behaviour; and
wherein the machine learning model is configured to predict a behaviour of normal cell operation.

8. The training unit of claim 7, wherein the processing unit is further configured to perform the steps of any of claims 2-6.

9. A computer-readable medium storing instructions which, when executed by a processor of a training unit for training a machine learning model for monitoring an electric battery system, wherein the electric battery system comprises at least one pack, each pack comprising a plurality of individual cells, the instructions cause the training unit to execute the method according to any one of claims 1-6.

10. A method for detecting anomalous behavior of cells in an electric battery system wherein the electric battery system comprises at least one pack, each pack comprising a plurality of individual cells, said method using a machine learning model, wherein the machine learning model is trained according to any of claims 1-6, the method comprising:
recording real-time data comprising a plurality of at least one of a voltage, current, temperature or pressure cell-level measurement for each of the plurality of cells while the electric battery system is operating;
defining a measured data set once an amount of recorded real-time data has surpassed a predetermined threshold;
inputting the dataset in the trained machine learning model, wherein the steps taken by the trained machine learning model include:
determining a predicted data set, wherein the predicted data set defines at least one of a voltage, current, temperature or pressure cell-level measurement for each of the plurality of cells during normal operation for each of the plurality of cells;
calculating an error function, wherein the error function is representative of the difference between the predicted data set and the measured data set for each of the plurality of cells; and
identifying anomalous cells based on the error function.

11. The method of claim 10, wherein the error function includes at least one of Mean Squared Error, Mean Absolute Error, R-Squared, Mean Absolute Percentage Error.

12. The method of any of claims 10-11, wherein identifying anomalous cells based on the error function further comprises using a clustering method, wherein using a clustering method comprises:
calculating a mean value of the error function of each of the segmented data sets;
placing the error function value of each cell on a one-dimensional axis;
calculating the absolute distance between each cell's error function value and the nearest error function values on the one-dimensional axis;
defining clusters of error function values, where a cluster is identified as a group of error function values with each having a distance to its nearest error function value neighbours that is less than a predetermined critical distance;
wherein the identifying further comprises flagging a cell as anomalous if the cell is not in a cluster; and,
wherein the clustering method includes at least one of Density-Based Spatial Clustering of Applications with Noise, or K-means.

13. The method of any of claims 10-11, wherein identifying anomalous cells based on the error function further comprises using a dynamic threshold method, wherein using a dynamic threshold method comprises:
calculating a mean value of the error function of each of the segmented data sets;
calculating a standard deviation of the error function of each of the segmented data sets;
defining a dynamic threshold, wherein the dynamic threshold is a sum of a predefined multiplier of the standard deviation and the mean value; and
wherein the identifying further comprises flagging a cell as anomalous if the error function is equal or greater than the dynamic threshold for a predefined fraction of the duration of the dataset.

14. The method of claim 10-13, further comprising updating the machine learning model after a preset use time of the electric battery system is reached, wherein the updating further comprises:
retraining the machine learning model using the recorded real-time data for each of the plurality of cells according to any one of claims 1-6.

15. An anomaly detection unit for detecting anomalous behavior of cells in an electric battery system wherein the electric battery system comprises at least one pack, each pack comprising a plurality of individual cells, said method using a machine learning model, wherein the machine learning model is trained according to any of claims 1-6, the anomaly detection unit comprising:
a processing unit configured to record real-time data comprising a plurality of at least one of a voltage, current, temperature or pressure cell-level measurement for each of the plurality of cells while the electric battery system is operating;
a processing unit configured to define a measured data set once an amount of recorded real-time data has surpassed a predetermined threshold;
the processing unit further configured to input the dataset in the trained machine learning model, wherein the steps taken by the trained machine learning model include:
the processing unit further configured to determine a predicted data set, wherein the predicted data set defines at least one of a voltage, current, temperature or pressure cell-level measurement for each of the plurality of cells during normal operation for each of the plurality of cells;
the processing unit further configured to calculate an error function, wherein the error function is representative of the difference between the predicted data set and the measured data set for each of the plurality of cells; and
the processing unit further configured to identify anomalous cells based on the error function.

16. The anomaly detection unit of claim 15, wherein the processing unit is further configured to perform the steps of any of claims 11-14.

17. A computer-readable medium storing instructions which, when executed by a processor of an anomaly detection unit for detecting anomalous behavior of cells in an electric battery system wherein the electric battery system comprises at least one pack, each pack comprising a plurality of individual cells, said method using a machine learning model, wherein the machine learning model is trained according to any of claims 1-6, the instructions cause the anomaly detection unit to execute the method according to any one of claims 10-14.
